# EUROPÄISCHE PATENTSCHRIFT

(11) **EP 3 583 466 B1**
(45) Veröffentlichungstag und Bekanntmachung des Hinweises auf die Patenterteilung: **01.04.2026**
(21) Anmeldenummer: 18708347.2
(22) Anmeldetag: 20.02.2018
(51) Int. Cl.: G03F 7/00, G03F 7/027, B64C 21/10

(54) **FLUGZEUGBAUTEIL MIT EINER MIKROSTRUKTURIERTEN OBERFLÄCHE**
AIRCRAFT COMPONENT COMPRISING A MICRO-STRUCTURED SURFACE
ÉLÉMENT D'AVION COMPORTANT UNE SURFACE MICROSTRUCTURÉE

(30) Priorität: 20.02.2017 DE 102017202675
(43) Veröffentlichungstag der Anmeldung: 25.12.2019
(73) Patentinhaber: Lufthansa Technik AG, 22335 Hamburg (DE)
(72) Erfinder: STADTLOBER, Barbara, 8044 Graz (AT); GÖTZ, Johannes, 8160 Weiz (AT); NEES, Dieter, 8160 Thannhausen (AT)
(74) Vertreter: Glawe, Delfs, Moll
(86) Internationale Anmeldenummer: PCT/EP2018/054063
(87) Internationale Veröffentlichungsnummer: WO 2018/150034

(56) Entgegenhaltungen:
- EP-A1- 1 923 406
- EP-A1- 2 502 942
- EP-A1- 2 848 656
- US-A1- 2011 049 089
- US-A1- 2013 040 073
- MARKUS LEITGEB ET AL: "Multilength Scale Patterning of Functional Layers by Roll-to-Roll Ultraviolet-Light-Assisted Nanoimprint Lithography", ACS NANO, vol. 10, no. 5, 5 April 2016 (2016-04-05), US, pages 4926 - 4941, XP055477172, ISSN: 1936-0851, DOI: 10.1021/acsnano.5b07411

## Beschreibung

Die vorliegende Erfindung betrifft ein Flugzeugbauteil beinhaltend eine mikrostrukturiere Oberfläche mit Riblet-Struktur bestehend aus einer Prägelackzusammensetzung, die aus einer Präpolymerzusammensetzung besteht.

Mikrostrukturierte Oberflächen sind für eine Vielzahl von Anwendungen vorteilhaft. Bekannte Beispiele sind sogenannte strömungsgünstige Riblet-Strukturen auf Oberflächen von relativ zu einem Fluid oder sonstigem Medium bewegten Teilen, beispielsweise Außenflächen von Luftfahrzeugen, Schiffen oder Rotorblättern von Windkraftanlagen. Ebenfalls Verwendung finden solche Strukturen beispielsweise an Innenflächen von Pipelines.

Zur Herstellung solcher Riblet-Strukturen ist die sogenannte Nanoimprintlithographie (NIL) geeignet. Bei NIL-Prozessen wird eine Polymerzusammensetzung durch mechanisches Prägen strukturiert. Es handelt sich hierbei um ein hoch präzises Prägeverfahren, bei dem es möglich ist, auch kleinste Strukturen auf einem entsprechenden Substrat auszuformen. Insbesondere können auf diese Weise Substrate, wie Folien, mit einer mikrostrukturierten Oberfläche versehen werden, die anschließend auf entsprechende Oberfläche aufgeklebt werden.

Mittels Rolle-zu-Rolle-UV-Nanoimprintlithographie (R2R-UV-NIL) können mikro- und nanostrukturierte Oberflächen, wie Ribletfolien, zur Strömungsreibungsreduktion großflächig und kostengünstig mit hohem Durchsatz hergestellt werden. Hierfür wird das auf einer Rolle befindliche Ausgangsmaterial auf einer Bahn aus beispielsweise Substratfolie mit in der Regel hohen Geschwindigkeiten abgerollt, bearbeitet und schließlich wieder aufgerollt. Als Ausgangsmaterialien können entsprechende Prägelacke dienen.

Solche Prägelacke sind aus dem Stand der Technik bekannt. In WO 2016/090395 A1 wird beispielsweise eine Präpolymerzusammensetzung offenbart durch die thiolhaltige Prägelacke erhalten werden. Aus EP 2 590 801 B1 ist ein Polymermaterial bekannt, das mindestens 60 Gew.-% Oligomer- und/oder Polymerverbindung, 2 bis 40 Gew.-% reaktiven Verdünner, 0,05 bis 10 Gew.-% hydrophober Zusatzstoffe und 0 bis 5 Gew.-% Photoinitiator umfasst.

EP 1 923 406 A1 offenbart durch sichtbares Licht härtbare Harzzusammensetzungen umfassend eine Phosphinoxidverbindung.

M. Leitgeb et al., Multilength Scale Patterning of Functional Layers by Roll-to-Roll Ultraviolet-Light-Assisted Nanoimprint Lithography, ACSNANO, Bd. 10, Nr. 5, 5. April 2016, beschreibt ein R2R-UV-NiL-Prägeverfahren.

EP 2 848 656 A1 beschreibt die Abschirmung von Metallsubstraten, z.B. Flugzeugbauteilen, mittels härtbarer Zusammensetzungen umfassend Urethandiacrylatoligomeren, Reaktivverdünner und Photoinitiator.

EP 2 502 942 A1 offenbart die Verwendung einer doppelt härtenden polymerisierbaren Zusammensetzung, umfassend mindestens ein Monomer, umfassend mindestens ein (Meth)acrylat und eine Kombination von mindestens einem Photoinitiator und einem wärmehärtenden Initiator als Einbettungsmaterial bei der Materialprüfung eines Substrats oder bei der Metallographie.

US 2011/049089 A1 offenbart ein durch UV-Strahlung härtbares Harzmaterial zur Übertragung von Mustern, welches Isobornylacrylat, ein Acrylat mit einem Fluorengerüst, ein polyfunktionelles Acrylat und einen Polymerisationsinitiator enthält.

US 2013/040073 A1 beschreibt die Herstellung von mikrostrukturierten Silikonoberflächen.

Normalerweise ist der Anteil an Reaktivverdünner in den Präpolymerzusammensetzungen gering, da ein höherer Anteil an Verdünner in der Regel zu einer höheren Sprödigkeit der Prägelacke führt und die Prägelacke daher nicht für alle Anwendungsbereiche, insbesondere nicht für Außenanwendungen, geeignet sind.

Der vorliegenden Erfindung liegt daher die Aufgabe zugrunde, eine Prägelackzusammensetzung und eine mikrostrukturierte Oberflächen bereitzustellen, die aufgrund einer niedrigeren Viskosität der Präpolymerzusammensetzung eine einfache Beschichtung ermöglich und trotzdem eine geringe Versprödung zeigen. Insbesondere sollen (UV-)NIL-Prägelacke für bewitterungsstabile und abrasionsfeste Ribletoberflächen, beispielsweise Ribletfolien, zur Reduzierung der Strömungsreibung von Verkehrsflugzeugen ermöglicht werden.

Die Erfindung löst diese Aufgabe durch ein Flugzeugbauteil beinhaltend eine mikrostrukturierte Oberfläche mit Riblet-Struktur bestehend aus einer gehärteten Prägelackzusammensetzung, die aus einer Präpolymerzusammensetzung besteht, die umfasst:
a) 1 bis 59,5 Gew.-% von wenigstens einer Oligomer- und/oder Polymerverbindung,
b) mehr als 40 Gew.-% von einem oder mehreren Reaktivverdünner ausgewählt aus (Meth)acrylat-Monomeren, wobei der Reaktivverdünner thiolfrei ist, und
c) wenigstens einen Photoinitiator.

Weitere bevorzugte Ausführungsformen werden in den Ansprüchen 2 bis 8 beschrieben.

Zunächst seien einige im Rahmen der Erfindung verwendete Begriffe erläutert.

Der Begriff Prägelack bezeichnet eine Zusammensetzung, die sich mittels einer geeigneten Vorrichtung auf eine Substratoberfläche aufbringen und dort zu einer mikrostrukturierten Oberfläche, insbesondere Riblet-strukturierten Oberfläche, aushärten lässt. Unter einer Präpolymerzusammensetzung ist dabei eine Art Zwischenprodukt auf Basis von Monomeren, Oligomeren und/oder Polymeren zu verstehen, das erst durch Härtung (d.h. Polymerisation) das auspolymerisierte Endprodukt bildet.

Das Aushärten des Prägelackes erfolgt bevorzugt mittels UV-Strahlung. Es können jedoch zusätzlich auch alle übrigen dem Fachmann bekannten Aushärtungsmechanismen verwendet werden. Gegebenenfalls kann zusätzlich auch eine thermische Aushärtung hinzutreten, insbesondere bei sogenannten Dual-Cure-Systemen.

Die gewünschte mikrostrukturierte Oberfläche wird in dem bereits aufgebrachten Prägelack vor oder während dessen Aushärtung erzeugt. Die Prägelacke sind zum Einsatz in Rolle-zu-Rolle, Rolle-zu-Platte oder Blatt-zu-Blatt-Verfahren geeignet. Besonders bevorzugt werden die Prägelacke in Rolle-zu-Rolle-UV-NIL-Verfahren eingesetzt und weisen sehr gute Abformungseigenschaften auf.

Erfindungsgemäß ist es bevorzugt, dass die Präpolymerzusammensetzung 41 bis 53 Gew.-%, vorzugsweise 47 Gew.-%, der wenigstens einen Oligomer- und/oder Polymerverbindung umfasst.

Erfindungsgemäß ist es ferner bevorzugt, dass die Präpolymerzusammensetzung 41 bis 53 Gew.-%, vorzugsweise 47 Gew.-%, von dem einen oder mehreren Reaktivverdünner ausgewählt aus (Meth)acrylat-Monomeren umfasst.

Erfindungsgemäß ist es bevorzugt vorgesehen, dass das Mischverhältnis von Oligomer- und/oder Polymerverbindung zu Reaktivverdünner 1:1 in der Präpolymerzusammensetzung ist.

Im Rahmen der vorliegenden Erfindung ist unter dem Begriff (Meth)acrylat-Monomer entweder ein Methacrylat-Monomer oder ein Acrylat-Monomer zu verstehen. Bevorzugt sind die (Meth)acrylat-Monomere der einzige Reaktivverdünner in der Präpolymerzusammensetzung. Dieses bedeutet, dass insbesondere keine anderen Typen von Reaktivverdünnern, wie beispielsweise thiolhaltige Monomere oder andere lediglich als Verdünner dienende Monomere, in der Präpolymerzusammensetzung eingesetzt werden. Unter thiolhaltigen Monomeren sind monomere Verbindungen zu verstehen, die wenigstens eine Thiolgruppe (-SH) als funktionelle Gruppe aufweisen. Die Lagerstabilität von thiolhaltigen UV-Lacken ist sehr begrenzt. Thiolhaltige Lacke härten häufig auch schon im Dunkeln innerhalb von Stunden bis Tagen aus. Daher ist es in der Regel notwendig, die Lacke erst kurz vor der Verarbeitung anzurühren, was meist unerwünscht ist. Weiterhin weisen derartige Lacke einen starken Geruch auf.

In einer bevorzugten Ausführungsform der Erfindung ist vorgesehen, dass das eine oder mehrere (Meth)acrylat-Monomere ausgewählt ist aus der Gruppe bestehend aus Hexandioldiacrylat (HDDA), Isobornylacrylat (IBOA), Norbonylacrylat, Decandioldiacrylat (DDDA), (2-Ethoxyethoxy)ethylacrylat(EOEOA), Phenoxyethylacrylat (PEA), Cyclohexylacrylat, 2-Ethylhexylacrylat, Tetrahydrofuran-Acrylat und ethoxiliertes Trimethylolpropantriacrylat (TMP(EO)xTA).

Weiter ist erfindungsgemäß bevorzugt, dass die wenigstens eine Oligomer- und/oder Polymerverbindung ausgewählt ist aus der Gruppe bestehend aus Polyurethanacrylaten, Polyacrylaten, Epoxidacrylaten, Silikonacrylaten, Polyetheracrylaten und Mischungen hiervon. In einer besonders bevorzugten Ausführungsform ist die wenigstens eine Oligomer- und/oder Polymerverbindung ein Urethan-Acrylat-Oligomer. Kommerziell erhältliche erfindungsgemäße Oligomer- und/oder Polymerverbindungen sind beispielsweise Ebecryl 8402, Ebecryl 4858, Ebecryl 4680 (Fa. Allnex) sowie Miramer PU2200 und Miramer PU2100 (Fa. Miwon).

In einer vorteilhaften Ausführungsform weist die Oligomer- und/oder Polymerverbindung auch reaktive (Meth)Acrylatgruppen auf.

In einer weiteren vorteilhaften Ausführungsform ist die Oligomer- und/oder Polymerverbindung Acryl-funktionalisiert.

Bevorzugt ist der wenigstens eine Photoinitiator ausgewählt aus der Gruppe bestehend aus (Alkyl-)-Benzoyl-Phenyl-Phosphinoxiden, 1-Hydroxyalkylphenylketonen, 2,2-Dimethoxy-1,2-diphenylethan-1-on, Thioxanthonen, Ketosulfonen und Mischungen hiervon. Die Photoinitiatoren werden vorzugsweise in einem Gewichtsanteil von etwa 3 Gew.-% in der Präpolymerzusammensetzung eingesetzt. Kommerziell erhältliche erfindungsgemäße Photoinitiatoren sind beispielsweise Omnirad TPO-L (IGM), Genocure TPO (Rahn), Genocure LTM (Rahn), Omnirad 819 (IGM).

Erfindungsgemäß ist es bevorzugt, dass weitere Bestandteile der Präpolymerzusammensetzung unabhängig voneinander ausgewählt sind aus:
d) UV-Absorbern,
e) Radikalfängern und
f) Antihaft-Additiven.

In einer bevorzugten Ausführungsform sind die Bestandteile Photoinitiator, UV-Absorber, Radikalfänger und/oder Antihaft-Additiv insgesamt mit einem Gewichtsanteil von 0,1 bis 18 Gew.-%, bevorzugt 0,5 bis 7 Gew.-%, noch bevorzugter etwa 6 Gew.-%, in der Gesamtzusammensetzung der Präpolymerzusammensetzung enthalten.

Erfindungsgemäß ist es bevorzugt vorgesehen, dass die UV-Absorber ausgewählt sind aus organischen und anorganischen UV-Absorbern. Bevorzugte organische UV-Absorber sind Hydroxyphenyltriazinen (HTP), Hydroxybenzotriazolen (HBT) und Mischungen hiervon. Die organischen UV-Absorber werden vorzugsweise in einem Gewichtsanteil von etwa 2 Gew.-% in der Präpolymerzusammensetzung eingesetzt. Kommerziell erhältliche erfindungsgemäße organische UV-Absorber sind beispielsweise Tinuvin 479 (BASF), Tinuvin 400 (BASF), Tinuvin 328 (BASF), Tinuvin 384-2 (BASF), Tinuvin 982 (BASF) und Tinuvin 1130 (BASF). Bevorzugte anorganische UV-Absorber sind Nanopartikel von TiO₂, ZrO₂, ZnO, CeO₂ und Mischungen hiervon.

Durch die Zugabe von UV-Absorber wird die UV-Stabilität der Prägelacke, bereits mit geringen Anteilen von vorzugsweise etwa 1 Gew.-%, signifikant erhöht. Auf diese Weise können die Prägelacke der außerordentlichen Belastung durch UV-Strahlung in Verkehrsflughöhe von mehr als 10000 Metern dauerhaft standhalten. Die Zugabe von anorganischen UV-Absorbern und insbesondere UV-absorbierenden anorganischen Nanopartikeln bietet zudem den Vorteil, dass diese eine größere UV-Stabilität und damit eine längere Lebensdauer aufweisen. Sie können aufgrund ihrer Härte insbesondere auch die Kratzfestigkeit und Abrasionsbeständigkeit zusätzlich erhöhen.

In einer bevorzugten Ausführungsform umfasst die Präpolymerzusammensetzung weiter wenigstens einen Radikalfänger. Bei einer bevorzugten Variante ist der Radikalfänger ein HALS (hindered amine light stabilizer / sterisch gehinderte Amin-Lichtstabilisator). Bevorzugte HALS sind Bis(1,2,2,6,6-pentamethyl-4-piperidyl)sebacat, Methyl-(1,2,2,6,6-pentamethyl-4-piperidyl)sebacat, Bis-(1-octyloxy-2,2,6,6-tetramethyl-4-piperidinyl)sebacat, 2,4-Bis[N-butyl-N[1-cyclohexyloxy-2,2,6,6-tetramethylpiperidin-4-yl)amino]-6-(2-hydroxyethylamine)-1,3,4-triazin und Mischungen hiervon. HALS werden vorzugsweise in einem Gewichtsanteil von etwa 1 Gew.-% eingesetzt. Kommerziell erhältliche erfindungsgemäße HALS sind beispielsweise Tinuvin 292 (BASF), CHISORB 292 (Bouble Bond Chemical Ind., Co., Ltd.), Tinuvin 123 (BASF) und Tinuvin 152 (BASF).

Bevorzugte Antihaft-Additive sind ausgewählt aus der Gruppe bestehend aus Alkyl-(Meth-)Acrylaten, Poly-Siloxan(Meth-)Acrylaten, Perfluoralkyl-(Meth-)Acrylaten, Perfluorpolyether-(Meth-)Acrylaten, Alkyl-Vinylethern, Poly-Siloxan-Vinylethern, Perfluoralkyl-Vinylethern und Perfluorpolyether-Vinylethern.

Normalerweise führt ein höherer Anteil an Reaktivverdünner zu einer höheren Sprödigkeit der ausgehärteten Prägelacke, so dass diese in der Regel nicht für Außenanwendungen und insbesondere zur Ausbildung von Riblet-Strukturen geeignet sind.

Überraschenderweise erfüllt die Prägelackzusammensetzung mit einem erhöhten Anteil von (Meth)acrylat-Monomer als Reaktivverdünner und einem niedrigen Anteil an Oligomer- und/oder Polymerverbindung die außerordentlich hohen Anforderungen zur Fertigung von Riblet-strukturierten Oberflächen für Verkehrsflugzeuge. Auf diese Weise können insbesondere UV-NIL-Prägelacke und entsprechende mikrostrukturierte Oberflächen mit hervorragender Bewitterungsstabilität und Abrasionsfestigkeit erhalten werden, die ein hohes Anwendungspotential zur Reduktion der Strömungsreibung in der Luftfahrt aufweisen.

Mikrostrukturierte Oberflächen weisen eine Struktur bzw. Topographie mit Erhebungen bzw. Vertiefungen auf, deren Abstand voneinander und Tiefe bzw. Höhe im Submillimeterbereich liegen. Bevorzugt liegen Abstand zueinander und Tiefe im Bereich 0,5 bis 100 µm, weiter vorzugsweise 0,5 bis 60 µm. Eine mikrostrukturierte Oberfläche ist im Rahmen der Erfindung eine Oberfläche mit Riblet-Struktur. Ein Riblet bezeichnet dabei eine Oberflächengeometrie, die eine Verminderung des Reibungswiderstandes auf in eine bestimmte Strömungsrichtung turbulent überströmten Oberflächen bewirkt.

Die Erfindung wird nun anhand einiger vorteilhafter Ausführungsformen beispielhaft beschrieben.

Es wurden Prägelackzusammensetzungen bestehend aus einer Präpolymerzusammensetzung enthaltend gleiche Anteile (1:1 Mischverhältnis) von Oligomer- und/oder Polymerverbindung zu (Meth)acrylat-Monomer als Reaktivverdünner hergestellt. In den vorliegenden Beispielen wurden jeweils 47 Gew.-% der Oligomer- und/oder Polymerverbindung und jeweils 47 Gew.-% des (Meth)acrylates als einzigem Reaktivverdünner eingesetzt. Tabelle 1 zeigt die in den Beispielen verwendeten Oligomer- und/oder Polymerverbindungen und (Meth)acrylat-Monomere als Reaktivverdünner.

**Tabelle 1: Verwendung von unterschiedlichen Oligomer- und/oder Polymerverbindungen und Reaktivverdünnern.**

| **Beispiel-nummer** | **47 Gew.-% Oligomer- und/oder Polymerverbindung** | **47 Gew.-% Reaktivverdünner** |
|---|---|---|
| 1 | E4858 | HDDA |
| 2 | E4858 | IBOA |
| 3 | E4858 | Cyclohexylacrylat |
| 4 | E4858 | 2-Ethylhexylacrylat |
| 5 | E4858 | THF-Acrylat |
| 6 | E8402 | HDDA |
| 7 | E8402 | IBOA |
| 8 | E8402 | Cyclohexylacrylat |
| 9 | E8402 | 2-Ethylhexylacrylat |
| 10 | E8402 | THF-Acrylat |
| 11 | E4680 | HDDA |
| 12 | E4680 | IBOA |
| 13 | E4680 | Cyclohexylacrylat |
| 14 | E4680 | 2-Ethylhexylacrylat |
| 15 | E4680 | THF-Acrylat |
| 16 | PU2100 | HDDA |
| 17 | PU2100 | IBOA |
| 18 | PU2100 | Cyclohexylacrylat |
| 19 | PU2100 | 2-Ethylhexylacrylat |
| 20 | PU2200 | THF-Acrylat |
| 21 | PU2200 | HDDA |
| 22 | PU2200 | IBOA |
| 23 | PU2200 | Cyclohexylacrylat |
| 24 | PU2200 | 2-Ethylhexylacrylat |
| 25 | PU2200 | THF-Acrylat |

Die kommerziell erhältlichen Verbindungen Ebecryl 8402 und Ebecryl 4858 (Fa. Allnex) sind aliphatische Urethan-Diacrylate. Ebecryl 4680 (Fa. Allnex) ist ein aliphatisches Urethan-Diacrylat, welches zusätzlich mit 1,6-Hexandioldiacrylat (HDDA) verdünnt ist. Bei den kommerziell erhältlichen Miramer PU2100 und PU2200 (Fa. Miwon) handelt es sich um Urethan-Diacrylate.

In den Beispielzusammensetzungen setzen sich die restlichen 6 Gew.-% der Präpolymerzusammensetzung aus den Anteilen von Photoinitiator (3 Gew.-% TPO-L), UV-Absorber (2 Gew.-% Tinuvin 479) und Radikalfänger (1 Gew.-% Tinuvin 292) zusammen. Optional ist auch die Zugabe von Antihaft-Additiven möglich.

Die Beispielformulierungen zeigen überraschenderweise trotz hoher Anteile an Reaktivverdünner eine erstaunlich geringe Sprödigkeit, so dass die Präpolymerzusammensetzungen als Prägelacke für Riblet-Strukturen geeignet sind. Die höhere Verdünnung ermöglicht aufgrund der geringeren Viskosität zudem eine einfachere Beschichtung der Prägelacke auf der Substratfolie in R2R-UV-NIL-Prägeverfahren. Die erhaltenen mikrostrukturierten Oberflächen zeichnen sich durch eine gute Bewitterungsbeständigkeit sowie Abrasionsbeständigkeit aus und sind daher besonders gut für Außenanwendungen geeignet.

## Patentansprüche

1. Flugzeugbauteil beinhaltend eine mikrostrukturierte Oberfläche mit Riblet-Struktur bestehend aus einer gehärteten Prägelackzusammensetzung, wobei die Prägelackzusammensetzung aus einer Präpolymerzusammensetzung besteht, die umfasst:
a) 1 bis 59,5 Gew.-% von wenigstens einer Oligomer- und/oder Polymerverbindung,
b) mehr als 40 Gew.-% von einem oder mehreren Reaktivverdünner ausgewählt aus (Meth)acrylatMonomeren, wobei der Reaktivverdünner thiolfrei ist, und
c) wenigstens einen Photoinitiator.

2. Flugzeugbauteil nach Anspruch 1, **dadurch gekennzeichnet, dass** die Präpolymerzusammensetzung 41 bis 53 Gew.-%, vorzugsweise 47 Gew.-%, der wenigstens einen Oligomer- und/oder Polymerverbindung umfasst.

3. Flugzeugbauteil nach Anspruch 1 oder 2, **dadurch gekennzeichnet, dass** die Präpolymerzusammensetzung 41 bis 53 Gew.-%, vorzugsweise 47 Gew.-%, von dem einen oder mehreren Reaktivverdünner ausgewählt aus (Meth)acrylatMonomeren umfasst.

4. Flugzeugbauteil nach einem der Ansprüche 1 bis 3, **dadurch gekennzeichnet, dass** das Mischungsverhältnis von Oligomer- und/oder Polymerverbindung zu Reaktivverdünner in Gewichtsprozenten 1:1 in der Präpolymerzusammensetzung ist.

5. Flugzeugbauteil nach einem der Ansprüche 1 bis 4, **dadurch gekennzeichnet, dass** die (Meth)acrylat-Monomere ausgewählt sind aus der Gruppe bestehend aus Hexandioldiacrylat, Isobornylacrylat, Norbornylacrylat, Decandioldiacrylat, (2-Ethoxyethoxy)ethylacrylat, Phenoxyethylacrylat, Cyclohexylacrylat, 2-Ethylhexylacrylat, Tetrahydrofuran-Acrylat und Trimethylolpropantriacrylat.

6. Flugzeugbauteil nach einem der Ansprüche 1 bis 5, **dadurch gekennzeichnet, dass** die wenigstens eine Oligomer- und/oder Polymerverbindung ausgewählt ist aus der Gruppe bestehend aus Polyurethanen, Polyacrylaten, Epoxidacrylaten, Silikonacrylaten, Polyetheracrylaten und Mischungen hiervon.

7. Flugzeugbauteil nach einem der Ansprüche 1 bis 6, **dadurch gekennzeichnet, dass** weitere Bestandteile der Präpolymerzusammensetzung unabhängig voneinander ausgewählt sind aus:
d) UV-Absorbern,
e) Radikalfängern und
f) Antihaft-Additiven.

8. Flugzeugbauteil nach Anspruch 7, **dadurch gekennzeichnet, dass** die Bestandteile Photoinitiator, UV-Absorber, Radikalfänger und/oder Antihaft-Additiv insgesamt mit einem Gewichtsanteil von 0,1 bis 18 Gew.-%, bevorzugt 0,5 bis 7 Gew.-%, noch bevorzugter 6 Gew.-%, in der Gesamtzusammensetzung der Präpolymerzusammensetzung enthalten sind.

## Claims

1. Aircraft component including a microstructured surface having a riblet structure consisting of a hardened embossing varnish composition, the embossing varnish composition consisting of a prepolymer composition comprising:
a) 1% to 59.5% by weight of at least one oligomeric compound and/or polymeric compound,
b) more than 40% by weight of one or more reactive diluents selected from (meth)acrylate monomers, the reactive diluent being thiol-free, and
c) at least one photoinitiator.

2. Aircraft component according to Claim 1, **characterized in that** the prepolymer composition comprises 41% to 53% by weight, preferably 47% by weight, of the at least one oligomeric compound and/or polymeric compound.

3. Aircraft component according to Claim 1 or 2, **characterized in that** the prepolymer composition comprises 41% to 53% by weight, preferably 47% by weight, of the one or more reactive diluents selected from (meth)acrylate monomers.

4. Aircraft component according to any of Claims 1 to 3, **characterized in that** the mixing ratio of oligomeric compound and/or polymeric compound to reactive diluents in per cent by weight is 1:1 in the prepolymer composition.

5. Aircraft component according to any of Claims 1 to 4, **characterized in that** the (meth)acrylate monomers are selected from the group consisting of hexanediol diacrylate, isobornyl acrylate, norbornyl acrylate, decanediol diacrylate, (2-ethoxyethoxy)ethyl acrylate, phenoxyethyl acrylate, cyclohexyl acrylate, 2-ethylhexyl acrylate, tetrahydrofuran acrylate and trimethylolpropane triacrylate.

6. Aircraft component according to any of Claims 1 to 5, **characterized in that** the at least one oligomeric compound and/or polymeric compound is selected from the group consisting of polyurethanes, polyacrylates, epoxy acrylates, silicone acrylates, polyether acrylates and mixtures thereof.

7. Aircraft component according to any of Claims 1 to 6, **characterized in that** further constituents of the prepolymer composition are selected independently from:
d) UV absorbers,
e) free-radical scavengers and
f) non-stick additives.

8. Aircraft component according to Claim 7, **characterized in that** the photoinitiator, UV absorber, radical scavenger and/or non-stick additive constituents are present in the overall composition of the prepolymer composition with a total proportion by weight of 0.1% to 18% by weight, preferably 0.5% to 7% by weight, more preferably 6% by weight.

## Revendications

1. Composant d'aéronef comprenant une surface microstructurée avec une structure à nervures constituée d'une composition de vernis gaufré durcie, la composition de vernis gaufré étant constituée d'une composition de prépolymère qui comprend :
a) 1 à 59,5 % en poids d'au moins un composé oligomère et/ou polymère,
b) plus de 40 % en poids d'un ou plusieurs diluants réactifs choisis parmi les monomères (méth)acrylate, le diluant réactif étant exempt de thiol, et
c) au moins un photo-initiateur.

2. Composant d'aéronef selon la revendication 1, **caractérisé en ce que** la composition de prépolymère comprend 41 à 53 % en poids, de préférence 47 % en poids, d'au moins un composé oligomère et/ou polymère.

3. Composant d'aéronef selon la revendication 1 ou 2, **caractérisé en ce que** la composition de prépolymère comprend 41 à 53 % en poids, de préférence 47 % en poids, d'un ou plusieurs diluants réactifs choisis parmi les monomères (méth)acrylate.

4. Composant d'aéronef selon l'une quelconque des revendications 1 à 3, **caractérisé en ce que** le rapport de mélange entre le composé oligomère et/ou polymère et le diluant réactif dans la composition de prépolymère est de 1:1 en pourcentage en poids.

5. Composant d'aéronef selon l'une quelconque des revendications 1 à 4, **caractérisé en ce que** les monomères (méth)acrylate sont choisis dans le groupe constitué par le diacrylate d'hexanediol, l'acrylate d'isobornyle, l'acrylate de norbornyle, le diacrylate de décanediol, l'acrylate de (2-éthoxyéthoxy)éthyle, l'acrylate de phénoxyéthyle, l'acrylate de cyclohexyle, l'acrylate de 2-éthylhexyle, l'acrylate de tétrahydrofuranne et le triacrylate de triméthylolpropane.

6. Composant d'aéronef selon l'une quelconque des revendications 1 à 5, **caractérisé en ce que** l'au moins un composé oligomère et/ou polymère est choisi dans le groupe constitué par les polyuréthanes, les polyacrylates, les époxyacrylates, les acrylates de silicone, les acrylates de polyéther et leurs mélanges.

7. Composant d'aéronef selon l'une quelconque des revendications 1 à 6, **caractérisé en ce que** d'autres constituants de la composition de prépolymère sont choisis indépendamment les uns des autres parmi :
d) les absorbeurs d'UV,
e) les piégeurs de radicaux et
f) les additifs antiadhésifs.

8. Composant d'aéronef selon la revendication 7, **caractérisé en ce que** les constituants photo-initiateur, absorbeur d'UV, piégeur de radicaux et/ou additif antiadhésif sont contenus au total en une proportion en poids de 0,1 à 18 % en poids, de préférence de 0,5 à 7 % en poids, et de manière encore plus préférée de 6 % en poids, dans la composition totale de la composition de prépolymère.
